# EUROPEAN PATENT APPLICATION

(11) **EP 4 497 622 A1**
(43) Date of publication of application: **29.01.2025**
(21) Application number: 23187854.7
(22) Date of filing: 26.07.2023
(51) Int. Cl.: B60L 1/00, G01R 21/133, B60L 53/62, B60L 53/63, B60L 53/66, B60L 53/68

(54) **METHOD AND SYSTEM FOR DETECTING ELECTRIC VEHICLE CHARGING SESSIONS IN A NET PROFILE**

(71) Applicant: Siemens Aktiengesellschaft, 80333 München (DE)
(72) Inventor: Heuer, Christian, 21220 Seevetal (DE); Merk, Stephan, 80804 München (DE); Tomaselli, Domenico, 81673 München (DE)
(74) Representative: Siemens Patent Attorneys

(57) **Abstract**

For detecting electric vehicle charging sessions in a whole household net profile, a first step (11) estimates an electric vehicle charger size from the net profile. A second step (12) identifies candidate windows associated with the charging of an electric vehicle based on the estimated charger size. In a third step (13), a machine learning model classifies the candidate windows into charging windows and unrelated windows, wherein each charging window indicates an electric vehicle charging session. The method needs only net-metering as input. No separate EV charger metering is needed for the detection. In an embodiment of the method, the machine learning model is picked from a set of machine learning models, depending on the estimated charger size. Each model in the set of machine learning models has been trained for a different charger size. The machine learning model receives as input suitable features that have been computed for the candidate windows.

## Description

Independent of the grammatical term usage, individuals with male, female or other gender identities are included within the term.

With increasing penetration of electric vehicles (electric vehicle will be abbreviated as "EV" in the following), distribution grids will be ever more stressed by the charging loads of electric vehicles at public and residential chargers. While the locations of public chargers and their measured load profiles are well known to utilities, this is often not the case for residential chargers, in particular in the US market. This is motivated by the fact that utility customers typically do not have to register their charging wall-boxes (in the following called residential chargers) with the utility and in most cases there is no dedicated meter for the residential charger but only power net metering, i.e., metering in two directions at the service delivery point (SDP) that measures the net load/production of all loads including EV charging and production units (e.g. photovoltaics) behind the SDP.

To estimate the current and future impact of residential EV charging on their distribution grids, utilities must identify the locations of residential chargers and estimate their sizing, i.e., the rated charging power of these chargers from power net metering. For more detailed analyses, such as calculating the current grid impact of EV charging, planning decentralized energy resource (DER) programs, as well as programs that incentivize customers to shift EV charging away from peak times, utilities need at least a rough EV disaggregation from power net loads, i.e., an identification of start, length and rough power profile of individual charging sessions.

US 2016/0223597 A1 discloses a method that consists of identifying candidate windows for EV charging from power net metering data of SDPs and then trying to fit various EV charging patterns against these candidate patterns. The disclosed method can be used for a net load disaggregation that dis-aggregates the EV load from the net load. The entire contents of that document are incorporated herein by reference.

It is an object of the invention to provide an alternative to the state of the art.

The objectives of the invention are solved by the independent claims. Further advantageous arrangements and embodiments of the invention are set forth in the respective dependent claims.

According to the method for detecting electric vehicle charging sessions in a net profile, the following operations are performed by components, wherein the components are hardware components and/or software components executed by one or more processors:
- receiving, by an interface, a net profile, which is a profile for a whole household and contains a series of time intervals, with each time interval being represented by a mean power net-metering value, wherein the duration of each time interval is in particular 5, 10, 15, or 60 minutes,
- estimating, by an estimating component processing the net profile, an electric vehicle charger size,
- identifying, by an identifying component processing the net profile, candidate windows associated with the charging of an electric vehicle based on the estimated charger size,
- classifying, by a machine learning model, the candidate windows into charging windows and unrelated windows, wherein each charging window indicates an electric vehicle charging session.

The system for detecting electric vehicle charging sessions in a net profile comprises the following components, wherein the components are hardware components and/or software components executed by one or more processors:
- an interface, configured for receiving a net profile, which is a profile for a whole household and contains a series of time intervals, with each time interval being represented by a mean power net-metering value, wherein the duration of each time interval is in particular 5, 10, 15, or 60 minutes,
- an estimating component, configured for processing the net profile and estimating an electric vehicle charger size,
- an identifying component, configured for processing the net profile and identifying candidate windows associated with the charging of an electric vehicle based on the estimated charger size, and
- a machine learning model, trained for classifying the candidate windows into charging windows and unrelated windows, wherein each charging window indicates an electric vehicle charging session.

The following advantages and explanations are not necessarily the result of the object of the independent claims. Rather, they may be advantages and explanations that only apply to certain embodiments or variants.

In connection with the invention, unless otherwise stated in the description, the terms "training", "generating", "computer-aided", "calculating", "determining", "reasoning", "retraining" and the like relate preferably to actions and/or processes and/or processing steps that change and/or generate data and/or convert the data into other data, the data in particular being or being able to be represented as physical quantities, for example as electrical impulses.

The term "computer" should be interpreted as broadly as possible, in particular to cover all electronic devices with data processing properties. Computers can thus, for example, be personal computers, servers, clients, programmable logic controllers (PLCs), handheld computer systems, pocket PC devices, mobile radio devices, smartphones, devices, or any other communication devices that can process data with computer support, processors, and other electronic devices for data processing. Computers can in particular comprise one or more processors and memory units.

In connection with the invention, a "memory", "memory unit" or "memory module" and the like can mean, for example, a volatile memory in the form of random-access memory (RAM) or a permanent memory such as a hard disk or a Disk.

The method and system, or at least some of their embodiments, need only net-metering as input. No separate EV charger metering is needed for the detection. The detected charging sessions can represent a full or a partial charging process of an electric vehicle.

In an embodiment of the method, the estimating operation (11) includes the steps of
- finding all plateau periods in the net profile with a minimal load of 6kW and a maximum fluctuation of 1.5kW,
- calculating a histogram with a bin size of 0.5kW representing a distribution of the mean net power of the time intervals in the resulting periods,
- using a peak finding algorithm to find peaks in the histogram using a distance between peaks of 1.5kW,
- from the peaks found by the peak finding algorithm, selecting the peak with the highest bin, and
- selecting, from a set of discrete charger sizes, a charger size that is nearest to this bin as the estimated charger size.

In another embodiment of the method, the identifying operation includes for each candidate window the steps of forming a core window by picking adjacent time intervals in the net profile if the mean net power of each of those time intervals is equal or greater than about two thirds of the rated power of the estimated charger size, and forming a full window by extending the core window by one, two, or three time intervals at the start and at the end.

In an embodiment of the method, the classifying operation includes the steps of, for each candidate window
- computing first features on the core window,
- computing second features on the full window,
- computing as a third feature a delta between a max net power in the core window and a min net power in the full window, and
- classifying, by the machine learning model receiving the first features, the second features, and the third feature as input, the candidate windows.

In a further embodiment of the method, the first features include
- a length of the core window,
- a max net power in the time intervals of the core window,
- a min net power in the time intervals of the core window,
- an average net power in the time intervals of the core window,
- a sum net power of the time intervals of the core window, and
- an average of an absolute first derivative of net power in the time intervals of the core window.

The second features include
- a maximum of an absolute first derivative of mean net power in the time intervals of the full window,
- an average of an absolute first derivate of mean net power in the time intervals of the full window, and
- a min net power in the time intervals of the full window.

The machine learning model is in particular a k-nearest neighbor algorithm or a random forest algorithm.

In an embodiment of the method, the machine learning model is picked from a set of machine learning models, depending on the estimated charger size. Each model in the set of machine learning models has been trained for a different charger size.

In another embodiment of the method, each model in the set of machine learning models has been trained with labelled windows, wherein the labels indicate in which windows there is a charging session.

In a further embodiment of the method, the labelled windows have been obtained from labelled net profiles metered by service delivery points and/or by electric vehicle chargers. As an alternative, the labelled windows have been obtained from synthetic household net profiles based on load models for individual appliances in a household.

In a further embodiment of the method, the synthetic household net profiles have been super-positioned with measured electric vehicle charging profiles to form the labelled windows.

The computer program product comprises instructions which, when the program is executed by a computer, cause the computer to carry out the method.

The provisioning device stores and/or provides the computer program product.

The foregoing and other aspects of the present invention are best understood from the following detailed description when read in connection with the accompanying drawings. For the purpose of illustrating the invention, the drawings show embodiments that are presently preferred. However, the invention is not limited to the specific instrumentalities disclosed. The embodiments may be combined with each other. Furthermore, the embodiments may be combined with any of the features described above. Unless stated otherwise, identical reference signs denote the same features or functionally identical elements between drawings. Included in the drawings are the following Figures:
- Fig. 1: shows a first embodiment,
- Fig. 2: shows another embodiment,
- Fig. 3: shows a flowchart of a possible exemplary embodiment of a method for detecting electric vehicle charging sessions in a net profile.

In the following description, various aspects of the present invention and embodiments thereof will be described. However, it will be understood by those skilled in the art that embodiments may be practiced with only some or all aspects thereof. For purposes of explanation, specific numbers and configurations are set forth in order to provide a thorough understanding. However, it will also be apparent to those skilled in the art that the embodiments may be practiced without these specific details.

The described components can each be hardware components or software components. For example, a software component can be a software module such as a software library; an individual procedure, subroutine, or function; or, depending on the programming paradigm, any other portion of software code that implements the function of the software component. A combination of hardware components and software components can occur, in particular, if some of the effects according to the invention are preferably exclusively implemented by special hardware (e.g., a processor in the form of an ASIC or FPGA) and some other part by software.

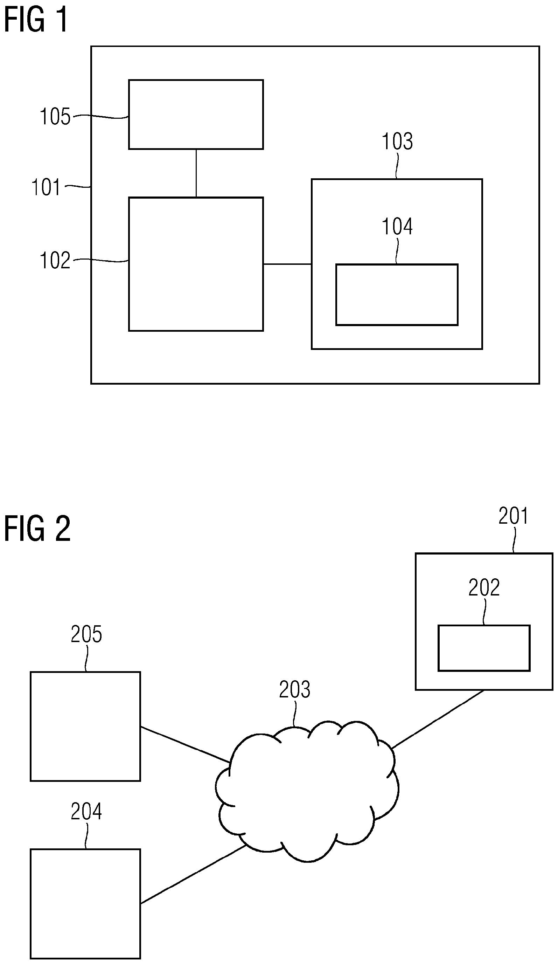

Fig. 1 shows one sample structure for computer-implementation of the invention which comprises:
- (101): computer system
- (102): processor
- (103): memory
- (104): computer program (product)
- (105): user interface

In this embodiment of the invention the computer program 104 comprises program instructions for carrying out the invention. The computer program 104 is stored in the memory 103 which renders, among others, the memory 103 and/or its related computer system 101 a provisioning device for the computer program 104. The computer system 101 may carry out the invention by executing the program instructions of the computer program 104 by the processor 102. Results of invention may be presented on the user interface 105. Alternatively, they may be stored in the memory 103 or on another suitable means for storing data.

Fig. 2 shows another sample structure for computer-implementation of the invention which comprises:
- (201): provisioning device
- (202): computer program (product)
- (203): computer network/Internet
- (204): computer system
- (205): mobile device/smartphone

In this embodiment the provisioning device 201 stores a computer program 202 which comprises program instructions for carrying out the invention. The provisioning device 201 provides the computer program 202 via a computer network/Internet 203. By way of example, a computer system 204 or a mobile device/smartphone 205 may load the computer program 202 and carry out the invention by executing the program instructions of the computer program 202.

In a variation of this embodiment, the provisioning device 201 is a computer-readable storage medium, for example a SD card, that stores the computer program 202 and is connected directly to the computer system 204 or the mobile device/smartphone 205 in order for it to load the computer program 202 and carry out the invention by executing the program instructions of the computer program 202.

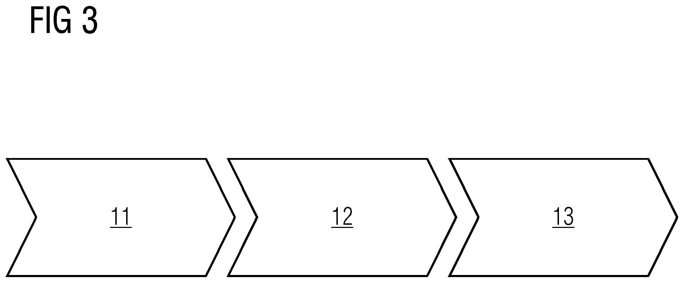

Figure 3 shows three steps according to a current embodiment of a method and system for detecting electric vehicle charging sessions in a net profile.

First an interface receives the net profile, which is a profile for a whole household and contains a series of time intervals, with each time interval being represented by a mean power net-metering value, wherein the duration of each time interval is in particular 5, 10, 15, or 60 minutes.

The interface is for example a network interface or simply an onboard interface for accessing a random access memory (RAM). If the net profile consists of energy consumption values instead of power values, the power values can be readily computed from the energy consumption values by multiplying them with 60 and dividing them by the duration of the time intervals.

In a first step 11, an estimating component processes the net profile and estimates an electric vehicle charger size.

In a second step 12, an identifying component processes the net profile and identifies candidate windows associated with the charging of an electric vehicle based on the estimated charger size.

In a third step 13, a machine learning model classifies the candidate windows into charging windows and unrelated windows, wherein each charging window indicates an electric vehicle charging session.

To identify individual EV charging sessions from net profiles that do not include generation e.g., from photovoltaics (PV), the current embodiment estimates the sizing of the EV charger, i.e., the peak power of the EV charger, in the first step 11. In the second step 12, the current embodiment identifies candidate windows associated with the charging of an electric vehicle. In the third step 13, the candidate windows are classified by a supervised machine learning (ML) approach into "Charging session" and "No charging session", in other words into charging windows and unrelated windows.

If the net profile includes generation from photovoltaics, an additional step is required at the beginning that disaggre-gates the photovoltaics production from the netload. In this case, the current embodiment subtracts the photovoltaics generation from the net profile and runs the EV disaggregation on the load-only net profile with the steps described above and below.

### Approach for estimating charger size

Residential level-2 chargers in the US often come in the following discrete sizes, for example 7.5kW, 9.6kW, 11.5kW and 19.2kW. Chargers in other markets e.g., in the EU have slightly different sizes, but again there are also only discrete sizes (e.g., 3 or 4). In some regions, up to ten different charger sizes are deployed in the field. Hence the problem of estimating the charger size from net profiles essentially means finding the most likely size out of the e.g., 3 or 4 pre-known classes. The current embodiment uses a sizing estimation approach that exploits three characteristics of EV charging. First, profiles of longer charging sessions have a rectangular shape and therefore show up as plateaus in the net profile (with some fluctuations from other loads). Second, residential charging is often done in the evening and night, when we can assume that the net profile is dominated by the charging session and allows us to identify the size of the charger. Third, chargers are high loads compared with other household loads.

Based on these characteristics the current embodiment estimates the charger size as follows:
▪ Find all plateau periods with a minimal load of 6kW, a length of 75-90 min and a maximum fluctuation (difference between maximum and minimum) of 1.5kW in the periods.
▪ Remove overlaps in the plateau periods and calculate a distribution histogram with a bin size of 0.5kW from the resulting periods.
▪ Using well known peak finding algorithms find peaks in the distribution histogram using a distance between peaks of 1.5kW and a min peak height of 3-5% of the complete distribution.
▪ Sort these peaks by the peak height and among the three top peaks select the one with the highest bin.
▪ From the discrete charger sizes take the one that is nearest to this bin.

First finding all plateau periods with a length of 75-90 min and later removing their overlap is optional, but makes the algorithm more efficient.

### Approach for identifying candidate windows

The current embodiment identifies candidate charging windows by first defining and then extracting features from the net loads. The current embodiment defines such features using domain knowledge. For example, the current embodiment recognizes, that charging is performed with at least 70% of rated power of the charger and hence a simple but robust approach for identifying candidate windows with a charging session would be to take all time intervals with mean net power > 0.7 * rated power of the charger. With that approach the current embodiment can capture the core of all charging sessions in which an EV is charged with at least 70% of the rated power of the charger for at least one time interval, i.e., at least 15 min if we assume mean net power data with 15 min resolution. Variants of the current and all other embodiments use about two thirds of the rated power of the charger as the threshold, for example 64%, 65%, 66%, 67%, 68%, 69%, or 70% as above.

Since charging sessions generally start and end randomly within the 15 min time grid of the net power measurements at SDPs, we will have mean charging power values below the rated charging power in the 15 min time intervals in which the charging starts and ends, even if the EV is charged at rated power for the full session. Therefore, the current embodiment extends the extracted windows by one 15 min time interval at the start and end to capture also the start and of the charging session.

From the explanation in the last paragraph, it should be clear that the current embodiment can only detect charging sessions that span at least three adjacent time intervals (measurement periods), i.e., whose length is longer than 15 minutes if we assume 15 min interval data (one time interval for the charging start, at least one time interval for the actual charging, and one time interval for the charging end).

A drawback of this approach using simple features (e.g., mean net power above 70%) to extract windows is that it also can capture periods with elevated net power due to other strong loads, e.g., clothing dryers. Therefore, we experimented with more sophisticated window extraction approaches that e.g., take the net power relative to the adjacent periods. But this approach comes with the problem of having to choose the interval in which we calculate the power difference and our experiments showed that overall accuracy is higher if we use the difference to the adjacent periods as an additional feature for identifying candidate windows. Therefore, the current embodiment extends the windows with mean net power >= 0.7 * rated charger power by one, two, or three time intervals at the start and end to be able to calculate the net power relative to immediately adjacent periods. We call the extracted window that includes these additional intervals at the start and end full window and the shorter period with mean net power >= 0.7 * rated charger power core window.

### Approach for classifying candidate windows

In the last step the current embodiment classifies the windows that were extracted in the previous step. This requires to first compute the determined features on the extracted windows. Some of these features are calculated on the full window while others are calculated only on the core window. The current embodiment relies on the following features:
▪ Length of core window
▪ Max net power in core window (on 15 min mean values)
▪ Min net power in core window (on 15 min mean values)
▪ Average net power in core window (on 15 min mean values)
▪ Sum net power in core window (on 15 min mean values)
▪ Average of absolute first derivative of net power in core window
▪ Max of absolute first derivative of mean net power in full window to cover the rise or drop respectively when a charging session starts/ends
▪ Average of absolute first derivate of mean net power in full window
▪ Delta between max net power in core window and min net power in full window (both based on 15 min mean values) to cover how elevated the core window is with respect to the immediate adjacent periods

Next, the current embodiment uses the features calculated on the candidate windows from the second step for classifying the candidate windows as "Charging session" or "No charging session" with a supervised machine learning model. Suitable machine learning based classification algorithms are e.g., k-nearest neighbor or random forest.

To train the supervised machine learning model, labelled net profiles are required, i.e., an annotation in which time intervals of the net profile there is a charging session. Then, a current embodiment uses the labelled net profiles to derive the labels of the windows, e.g., using the simple rule where a window is labelled as "Charging session" if at least 50% of the window overlaps with a "Is Charging" annotation. The easiest way of obtaining such labels for training would be a subset of residential SDPs in which there is a net meter and a dedicated meter for the EV charger which immediately provides the required labels. While penetration of dedicated charger metering is low, such meters exist since some customers need them for tax reasons.

An alternative to using real measured net profiles together with labels from dedicated charger metering would be the use of synthesized or semi-synthesized data for training. E.g., the National Renewable Energy Laboratory (NREL) in the US provides a rich set of synthetic residential net load profiles. These profiles are based on detailed load models for individual appliances (e.g., stoves, HVAC, lighting, plug loads like TVs ...) in a household. If such profiles already include a disaggregated EV profile, a current embodiment can use them for labelling the net profiles/windows.

If EV profiles are not included and if it is known that the net profiles do not include load from residential EV chargers, another embodiment can use these synthetic profiles together with measured EV sessions (e.g. from publicly available data sets) to create net profiles with EV charging by super-positioning the synthetic household net loads (without EV charging) with EV sessions as described in the following section.

The simple superposition of plain household profiles with EV charging profiles to a net profile would be not appropriate, as in a real setting there are correlations between the plain household loads and the charging sessions, e.g., without a special EV charging management system people start charging typically immediately after they arrive at home and at the same time household loads also go up since people switch on lights, their HVAC or their TV, or start cooking. Not accounting for these correlations when creating the net profiles would on the one side make the task simpler, but on the other side the developed identification algorithms less robust since detecting a charging session against a low load period is easier than detecting it during a period with other loads.

Since typically the synthetic household net profiles and the measured charging profiles originate from different sources, they are not aligned and on an individual profile level will not show conventional correlations between household and EV charging profiles, e.g., that EV charging typically starts when people arrive at home and other loads (e.g., from stoves, lighting ...) also increase. Therefore, the current embodiment uses the following algorithm for their alignment which comprises the following building blocks:
1. Break down measured charging profiles into individual charging sessions
2. From the charging profiles and the extracted charging sessions calculate for each time interval (e.g., hour or 15 min) a statistic determining the probability that a charging session starts in this time interval.
3. For each time interval put all charging sessions extracted in step 1 in an array that, irrespective of their length, start in that time interval.
4. For each synthetic household profile:
   a. Analyze the household profile and find points in time with indications that a customer has arrived at home. If the household profiles include measurements for individual appliances (e.g., lighting, plug loads, heating, cooling, ...) this can be achieved for example using the profiles of such individual appliances (e.g., plug loads including for example the television or interior lighting, whose increase from a low level is closely correlated with the times when customers arrive at home).
   b. Run through the household profile and at all points that are marked in step 4.a. as "customer arrived at home" use the statistics derived in step 2 to determine whether to start a charging session or not. If a charging session is started sample a random session for the respective hour from the arrays created in step 3 and check that the session does not interfere with a session started before.
   c. Generate the net profile by super-positioning the plain household profile with the sampled sessions from the step before.

The approach with the statistics on charging-start and session length depending on start time could be replaced with other approaches e.g., multi-agent-based simulations of residential charging behavior.

The described approach for identifying residential charging sessions from net metering needs separate classification models for each charger size, since the session profiles of chargers with different sizes significantly differ, e.g., sessions from chargers with high power rating are shorter and typically show a decrease of charging power towards the end of a full charging session. But since there exist only a few charger sizes, e.g., 7.2kW, 9.6kW, 11.5kW and 19.2kW in the US, the number of required classification models is low.

In general, one can expect that classification models trained on data from one utility or on semi-synthetic data can be transferred to other utilities as long as the general load patterns of the utility customers are comparable. This transferability of classification models is based on the assumption that the profiles of EV charging sessions are mainly determined by the chargers and the charged vehicles and therefore should not significantly differ between utilities.

For example, the method can be executed by one or more processors. Examples of processors include a microcontroller or a microprocessor, an Application Specific Integrated Circuit (ASIC), or a neuromorphic microchip, in particular a neuromorphic processor unit. The processor can be part of any kind of computer, including mobile computing devices such as tablet computers, smartphones or laptops, or part of a server in a control room or cloud.

The above-described method may be implemented via a computer program product including one or more computer-readable storage media having stored thereon instructions executable by one or more processors of a computing system. Execution of the instructions causes the computing system to perform operations corresponding with the acts of the method described above.

The instructions for implementing processes or methods described herein may be provided on non-transitory computer-readable storage media or memories, such as a cache, buffer, RAM, FLASH, removable media, hard drive, or other computer readable storage media. Computer readable storage media include various types of volatile and non-volatile storage media. The functions, acts, or tasks illustrated in the figures or described herein may be executed in response to one or more sets of instructions stored in or on computer readable storage media. The functions, acts or tasks may be independent of the particular type of instruction set, storage media, processor or processing strategy and may be performed by software, hardware, integrated circuits, firmware, micro code, and the like, operating alone or in combination. Likewise, processing strategies may include multiprocessing, multitasking, parallel processing, and the like.

The invention has been described in detail with reference to embodiments thereof and examples. Variations and modifications may, however, be effected within the spirit and scope of the invention covered by the claims. The phrase "at least one of A, B and C" as an alternative expression may provide that one or more of A, B and C may be used.

## Claims

1. A computer implemented method for detecting electric vehicle charging sessions in a net profile, wherein the following operations are performed by components, and wherein the components are hardware components and/or software components executed by one or more processors:
- receiving, by an interface, a net profile, which is a profile for a whole household and contains a series of time intervals, with each time interval being represented by a mean power net-metering value, wherein the duration of each time interval is in particular 5, 10, 15, or 60 minutes,
- estimating (11), by an estimating component processing the net profile, an electric vehicle charger size,
- identifying (12), by an identifying component processing the net profile, candidate windows associated with the charging of an electric vehicle based on the estimated charger size,
- classifying (13), by a machine learning model, the candidate windows into charging windows and unrelated windows, wherein each charging window indicates an electric vehicle charging session.

2. The method according to claim 1,
- wherein the estimating operation (11) includes the steps of
- finding all plateau periods in the net profile with a minimal load of 6kW and a maximum fluctuation of 1.5 kW,
- calculating a histogram with a bin size of 0.5kW representing a distribution of the mean net power of the time intervals in the resulting periods,
- using a peak finding algorithm to find peaks in the histogram using a distance between peaks of 1.5kW,
- from the peaks found by the peak finding algorithm, selecting the peak with the highest bin, and
- selecting, from a set of discrete charger sizes, a charger size that is nearest to this bin as the estimated charger size.

3. The method according to any of the preceding claims,
- wherein the identifying operation (12) includes for each candidate window the steps of
- forming a core window by picking adjacent time intervals in the net profile if the mean net power of each of those time intervals is equal or greater than about two thirds of the rated power of the estimated charger size, and
- forming a full window by extending the core window by one, two, or three time intervals at the start and at the end.

4. The method according to claim 3,
- wherein the classifying operation (13) includes the steps of, for each candidate window
- computing first features on the core window,
- computing second features on the full window,
- computing as a third feature a delta between a max net power in the core window and a min net power in the full window, and
- classifying, by the machine learning model receiving the first features, the second features, and the third feature as input, the candidate windows.

5. The method according to claim 4,
- wherein the first features include
- a length of the core window,
- a max net power in the time intervals of the core window,
- a min net power in the time intervals of the core window,
- an average net power in the time intervals of the core window,
- a sum net power of the time intervals of the core window, and
- an average of an absolute first derivative of net power in the time intervals of the core window,
- wherein the second features include
- a maximum of an absolute first derivative of mean net power in the time intervals of the full window,
- an average of an absolute first derivate of mean net power in the time intervals of the full window, and
- a min net power in the time intervals of the full window, and
- wherein the machine learning model is in particular a k-nearest neighbor algorithm or a random forest algorithm.

6. The method according to any of the preceding claims,
- wherein the machine learning model is picked from a set of machine learning models, depending on the estimated charger size, and
- wherein each model in the set of machine learning models has been trained for a different charger size.

7. The method according to claim 6,
- wherein each model in the set of machine learning models has been trained with labelled windows, wherein the labels indicate in which windows there is a charging session .

8. The method according to claim 7,
- wherein the labelled windows have been obtained from labelled net profiles metered by service delivery points and/or by electric vehicle chargers, or
- wherein the labelled windows have been obtained from synthetic household net profiles based on load models for individual appliances in a household.

9. The method according to claim 8,
- wherein the synthetic household net profiles have been super-positioned with measured electric vehicle charging profiles to form the labelled windows.

10. A system for detecting electric vehicle charging sessions in a net profile, comprising:
- an interface, configured for receiving a net profile, which is a profile for a whole household and contains a series of time intervals, with each time interval being represented by a mean power net-metering value, wherein the duration of each time interval is in particular 5, 10, 15, or 60 minutes,
- an estimating component, configured for processing the net profile and estimating (11) an electric vehicle charger size,
- an identifying component, configured for processing the net profile and identifying (12) candidate windows associated with the charging of an electric vehicle based on the estimated charger size, and
- a machine learning model, trained for classifying (13) the candidate windows into charging windows and unrelated windows, wherein each charging window indicates an electric vehicle charging session.

11. A computer program product comprising instructions which, when the program is executed by a computer, cause the computer to carry out a method according to one of the method claims.

12. A provisioning device for the computer program product according to the preceding claim, wherein the provisioning device stores and/or provides the computer program product.
